# EUROPÄISCHE PATENTSCHRIFT

(11) **EP 1 189 496 B1**
(45) Veröffentlichungstag und Bekanntmachung des Hinweises auf die Patenterteilung: **28.10.2009**
(21) Anmeldenummer: 01203005.2
(22) Anmeldetag: 07.08.2001
(51) Int. Cl.: H05K 13/04, H01L 21/00

(54) **Vorrichtung für die Montage von Halbleiterchips**
Apparatus for mounting semiconductor chips
Dispositif pour le montage de puces à base de semiconducteur

(30) Priorität: 13.09.2000 EP 00810824
(43) Veröffentlichungstag der Anmeldung: 20.03.2002
(73) Patentinhaber: Esec AG, 6330 Cham (CH)
(72) Erfinder: Mannhart, Eugen, 6330 Cham (CH); Günther, Thomas, 8800 Thalwil (CH); Leu, Felix, 6300 Zug (CH); Dschen, Tsing, 8953 Dietikon (CH)
(74) Vertreter: Falk, Urs

(56) Entgegenhaltungen:
- EP-A- 0 907 311
- US-A- 5 324 087

## Beschreibung

Die Erfindung betrifft eine Vorrichtung für die Montage von Halbleiterchips der im Oberbegriff des Anspruchs 1 genannten Art.

Für die Montage von Halbleiterchips werden als Montageautomat sogenannte Die Bonder eingesetzt, bei denen ein Bondkopf den zu montierenden Halbleiterchip an einem ersten Ort aufnimmt und an einem zweiten Ort auf einem Substrat plaziert. Der Bondkopf weist einen mit ein Vakuumdüse versehenes Greiforgan auf, mit dem der Halbleiterchip während des Transports gehalten wird. Für die Überprüfung, ob der Halbleiterchip erfolgreich ergriffen wurde, sind verschiedene Messsysteme entwickelt worden. Bei einem ersten Messsystem befindet sich im Bondkopf am oberen Ende der Vakuumdüse ein Photosensor. Auf dem Weg vom ersten Ort zum Substrat überfährt das Greiforgan eine Lichtquelle, die im Photosensor dann einen Lichtimpuls erzeugt, wenn sich kein Halbleiterchip am Greiforgan befindet.

Ein solches System ist aus dem Dokument EP-A-0 907 311 bekannt.

Eine optimale Ausbildung des Messsystems ist aus Platzgründen nicht möglich, da der Bondkopf verschiedene Funktionen bei möglichst geringer Masse erfüllen muss.

Bei einem weiteren bekannten Messsystem wird der Halbleiterchip auf dem Transportweg durch eine Lichtschranke geführt. Nachteilig bei diesem System ist, dass die Lichtschranke exakt auf die Transporthöhe justiert werden muss.

Die Messung der Stärke des Vakuums in der Vakuumdüse, das grösser sein sollte, wenn der Halbleiterchip ergriffen ist und die Düse abdichtet, hat sich nur teilweise als tauglich erwiesen, da die Abdichtung durch den Halbleiterchip bei Die-Collet Greiforganen oftmals sehr schlecht ist.

Der Erfindung liegt die Aufgabe zugrunde, ein Messsystem zu entwickeln, das zuverlässig nachweist, ob sich am Greiforgan ein Halbleiterchip befindet, und das nicht justiert werden muss.

Die genannte Aufgabe wird erfindungsgemäss gelöst durch die Merkmale des Anspruchs 1.

Die Lösung der Aufgabe gelingt mit einem Messsystem, bei dem das von einer Lichtquelle ausgestrahlte Licht, das bei Abwesenheit des Halbleiterchips in die Längsbohrung des Greiforgans gelangt, mittels eines optischen Umlenkelementes senkrecht radial zur Längsbohrung ausgekoppelt und zur Detektion einem Photosensor zugeführt wird. Das Messsystem ist zudem bevorzugt mit einem Reflektor versehen, um einen möglichst grossen Anteil des seitlich austretenden Lichtes auf den Photosensor umzulenken.

Nachfolgend werden Ausführungsbeispiele der Erfindung anhand der Zeichnung näher erläutert. Die Figuren sind nicht massstabsgetreu.

Es zeigen:
- Fig. 1: eine Vorrichtung für die Montage von Halbleiterchips mit einem Bondkopf mit einem Greiforgan,
- Fig. 2: im Querschnitt den Bondkopf mit einem erfindungsgemässen Messsystem,
- Fig. 3: ein erstes Ausführungsbeispiel des Messsystems in der Aufsicht,
- Fig. 4: Details des Greiforgans,
- Fig. 5: ein zweites Ausführungsbeispiel des Messsystems, und
- Fig. 6: ein drittes Ausführungsbeispiel des Messsystems.

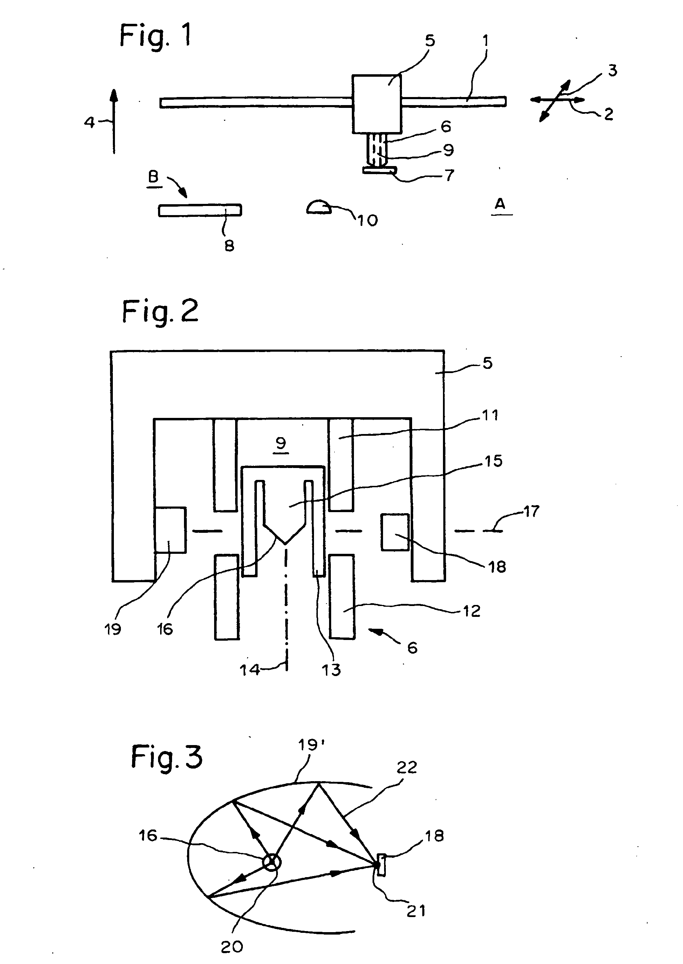

Die Fig. 1 zeigt die für das Verständnis der Erfindung nötigen Teile einer Vorrichtung für die Montage von Halbleiterchips, wie sie beispielsweise aus der europäischen Patentanmeldung EP 923 111 bekannt ist. Die Vorrichtung umfasst ein sogenanntes, in zwei kartesischen Koordinatenrichtungen 2, 3 bewegbares Pick and Place System 1 mit einem in vertikaler Richtung 4 heb- und senkbaren Bondkopf 5 mit einem Greiforgan 6 zum Transportieren eines Halbleiterchips 7 von einem ersten Ort A zu einem zweiten Ort B, wo der Halbleiterchip 7 auf einem Substrat 8 plaziert wird.

Das Greiforgan 6 weist eine Längsbohrung 9 auf, die mit Vakuum beaufschlagbar ist, um den Halbleiterchip 7 zu ergreifen. Auf dem Weg vom Ort A zum Ort B überfährt der Bondkopf 5 eine ortsfest angeordnete Lichtquelle 10. Wenn der Halbleiterchip 7 am Greiforgan 6 haftet, gelangt beim Überfahren der Lichtquelle 10 kein Licht der Lichtquelle 10 in die Längsbohrung 9. Ist kein Halbleiterchip 7 am Greiforgan 6 vorhanden, dann gelangt Licht der Lichtquelle 10 in die Längsbohrung 9.

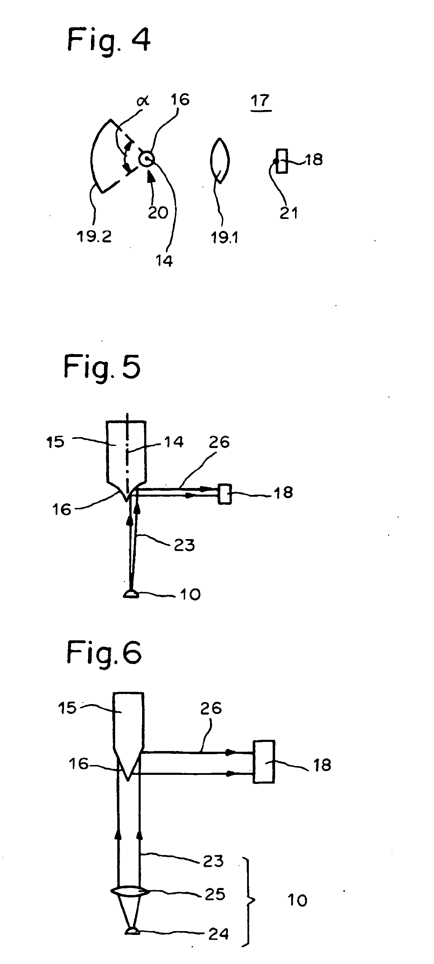

Die Fig. 2 zeigt im Querschnitt den Bondkopf 5 mit dem Greiforgan 6 und einem Messsystem zur Detektion des bei Abwesenheit des Halbleiterchips 7 in die Längsbohrung 9 gelangenden Lichtes der Lichtquelle 10. Das Greiforgan 6 ist gegenüber dem Bondkopf 5 in der vertikalen Richtung 4 verschiebbar und um seine Längsachse drehbar. Das Greiforgan 6 besteht aus einem oberen Teil 11 und einem unteren Teil 12, die beide lichtundurchlässig sind. Das obere Teil 11 und das untere Teil 12 sind durch ein für das Licht der Lichtquelle 10 durchlässiges Kupplungsstück 13 verbunden. Das Kupplungsstück 13 ist in die Längsbohrung 9 im oberen Teil 11 und in die Längsbohrung 9 im unteren Teil 12 eingesteckt. Das Kupplungsstück 13 weist einen auf der Symmetrieachse 14 der Längsbohrung 9 zentrierten Körper 15 mit einer verspiegelten Spitze 16 auf. Die Spitze 16 ist rotationssymmetrisch bezüglich der Längsachse 14 der Längsbohrung 9. Die die Spitze 16 bildende Fläche ist beispielsweise kegelförmig und weist gegenüber der vertikalen Richtung 4 einen Winkel von 45° auf, so dass von unten in die Längsbohrung 9 einfallendes Licht der Lichtquelle 10 an der Spitze 16 in die horizontale Ebene 17 umgelenkt wird und seitlich aus dem Greiforgan 6 austritt. Am Bondkopf 5 sind ein Photosensor 18 zur Messung des seitlich austretenden Lichtes und mindestens ein optisches Element 19 zur Umlenkung und/oder Konzentration des in die horizontale Ebene 17 austretenden Lichtes auf den Photosensor 18 angeordnet. Aus Gründen der zeichnerischen Klarheit ist das optische Element 19 nur schematisch angedeutet; Einzelheiten über seine Lage und Ausdehnung sind den nachfolgenden Figuren 3 und 5 zu entnehmen. Der Photosensor 18 ist beispielsweise eine Photodiode oder ein Phototransistor.

Beim ersten Ausführungsbeispiel ist das optische Element 19 ein Reflektor mit einer elliptischen Form, wobei sich die verspiegelte Spitze 16 im einen Brennpunkt 20 (Fig. 3) der Ellipse und der Photosensor 18 im anderen Brennpunkt 21 (Fig. 3) der Ellipse befindet. Somit wird das in die horizontale Ebene 17 austretende Licht unabhängig von der Richtung, die es in der horizontalen Ebene 17 einnimmt, auf den Photosensor 18 umgelenkt.

Die Fig. 3 zeigt den elliptischen Reflektor 19', die verspiegelte Spitze 16 und den Photosensor 18 in einem Schnitt durch die horizontale Ebene 17. Eingezeichnet sind auch die beiden Brennpunkte 20 und 21 der Ellipse, sowie verschiedene Strahlenwege 22 des an der Spitze 16 umgelenkten Lichtes. Der elliptische Reflektor 19' ist nicht vollständig geschlossen, da das an ihm reflektierte Licht von vorne auf den Photosensor 18 auffallen muss. Mit dem elliptischen Reflektor 19' können etwa 80% des seitlich austretenden Lichtes auf dem Photosensor 18 konzentriert werden.

Die Fig. 4 zeigt ein zweites Ausführungsbeispiel, bei dem zwei optische Elemente 19.1 und 19.2 vorhanden sind, um das in die horizontale Ebene 17 umgelenkte Licht auf den Photosensor 18 zu leiten. Das erste optische Element 19.1 ist eine Linse, die einen Teil des an der Spitze 16 umgelenkten Lichtes auf den Photosensor 18 abbildet. Die numerische Apertur der Linse ist möglichst gross. Bei einer numerischen Apertur von 0.5 beträgt der Öffnungswinkel 60°, so dass etwa 17% des in die horizontale Ebene 17 austretenden Lichtes zum Photosensor 18 geleitet werden. Die Symmetrieachse 14 durchstösst den Brennpunkt 20 der Linse. Der Photosensor 18 befindet sich im Brennpunkt 21 der Linse. Das zweite optische Element 19.2 ist ein Reflektor mit annähernd zylindrischer Form und mit einem Umfangswinkel von ebenfalls etwa 60°, der das auf ihn fallende Licht zurückreflektiert, so dass es via Linse ebenfalls zum Photosensor gelangt. Der Reflektor sollte das Licht so reflektieren, dass es möglichst an der Spitze des Körpers 15 vorbei zur Linse gelangt. Wegen der Abschattung durch die Spitze 16 des Körpers 5 müssen gewisse Verluste in Kauf genommen werden, die etwa 10 - 40% ausmachen können. Als Linse kann z.B. eine biasphärische Kunststofflinse mit einer Antireflex Beschichtung verwendet werden.

Bei einem dritten Ausführungsbeispiel umfasst das Messsystem nur das erste optische Element 19.1, also die Linse, nicht aber das zweite optische Element 19.2, das ist der Reflektor 19.2, des zweiten Ausführungsbeispiels. Dies erlaubt jedoch nur einen kleinen Teil des an der Spitze 16 umgelenkten Lichtes auf den Photosensor 18 zu fokussieren.

Das von der Lichtquelle 10 ausgesandte und in die Längsbohrung 9 gelangte Licht weist eine gewisse Strahlbreite auf. Die lichtempfindliche Fläche des Photosensors 18 muss sich deshalb in vertikaler Richtung genügend weit erstrecken, um möglichst alles von der Lichtquelle 10 stammende Licht zu erfassen. Die Ausdehnung des Photosensors 18 in vertikaler Richtung 4 kann jedoch verkleinert werden, wenn die lichtumlenkende Spitze 16 des Körpers 15 und/oder die Reflektoren an die Eigenschaften der von der Lichtquelle 10 ausgesandten Lichtstrahlen 23 (Fig. 5) angepasst werden.

Wenn als Lichtquelle z.B. eine herkömmliche Leuchtdiode ohne zusätzliche optische Elemente verwendet wird, dann verlaufen die von ihr ausgesandten Lichtstrahlen nicht parallel, sondern divergent.

Die die Spitze 16 des Körpers 15 bildende Fläche ist deshalb, wie in der Fig. 5 gezeigt ist, bevorzugt gekrümmt ausgebildet, um die am Körper 15 reflektierten Lichtstrahlen 26 in vertikaler Richtung auf den Photosensor 18 zu fokussieren. Beim ersten Ausführungsbeispiel ist die Krümmung einerseits der Divergenz der Lichtstrahlen 23 und andererseits der Länge der Strahlenwege 22 (Fig. 3) vom Körper 15 bis zum Photosensor 18 anzupassen. Beim zweiten Ausführungsbeispiel ist die Krümmung einerseits der Divergenz der Lichtstrahlen 23 und andererseits entweder der Länge des Weges der direkt zum Photosensor 18 oder der Länge des Weges der via den Reflektor indirekt zum Photosensor 18 gelangenden Lichtstrahlen anzupassen. Bevorzugt wird bei diesem Beispiel die die Spitze 16 des Körpers 15 bildende Fläche mit Vorteil so gekrümmt ausgebildet, dass die reflektierten Strahlen die Spitze des Körpers 15 als parallele Strahlen 24 verlassen. Der Vorteil liegt darin, dass unterschiedliche Weglängen zwischen den Lichtstrahlen, die den Photosensor 18 nach der Reflektion am Körper 15 direkt erreichen, und den Lichtstrahlen, die den Photosensor 18 erst nach der Reflexion am Reflektor erreichen, keine Rolle spielen.

Eine andere Möglichkeit besteht darin, wie in der Fig. 6 gezeigt ist, eine Lichtquelle 10 zu verwenden, die annähernd Licht aus parallelen Strahlen 23 aussendet. Eine solche Lichtquelle 10 umfasst beispielsweise eine Leuchtdiode 24 und eine Linse 25, wobei sich die Leuchtdiode 24 im Brennpunkt der Linse 25 befindet. Die reflektierende Fläche des Körpers 15 ist dann bevorzugt als Kegelspitze ausgebildet, so dass das aus parallel einfallenden Strahlen bestehende Licht 23 den Körper 15 auch als Licht paralleler Strahlen 26 verlässt. Die reflektierende Fläche des Körpers 15 kann aber auch gekrümmt sein, um das Licht in vertikaler Hinsicht auf den Photosensor 18 zu fokussieren.

Bei den beschriebenen Ausführungsbeispielen bestehen die Reflektoren beispielsweise aus hochglanzpoliertem Aluminium.

Um Fehler durch Fremdlicht zu vermeiden, sind das bzw. die optischen Elemente 19 und der Photosensor 18 bevorzugt in einem lichtundurchlässigen Gehäuse untergebracht. Zudem wird bevorzugt die bekannte Lock-In Technik verwendet, bei der das Licht der Lichtquelle 10 moduliert wird. Weiter wird die Lichtquelle bevorzugt im Pulsbetrieb betrieben, d.h. sie wird jeweils nur dann kurzzeitig eingeschaltet, wenn das Greiforgan 6 die Lichtquelle 10 passiert. Im Pulsbetrieb kann die Lichtquelle 10 mit einem höheren Strom beaufschlagt werden als im Dauerbetrieb, was die Messempfindlichkeit erhöht.

Dank der Rotationssymmetrie der Spitze 16 ist das Messresultat unabhängig von der momentanen Drehlage des Greiforgans 6.

## Patentansprüche

1. Vorrichtung für die Montage von Halbleiterchips, mit einem Bondkopf (5) mit einem Greiforgan (6) mit einer mit Vakuum beaufschlagbaren Längsbohrung (9) zum Erfassen und Transportieren eines Halbleiterchips (7), und mit einer Lichtquelle (10) und einem Photosensor (18) zum Nachweis, ob das Greiforgan (6) den Halbleiterchip (7) ergriffen hat, wobei bei Abwesenheit des Halbleiterchips (7) Licht der Lichtquelle (10) in die Längsbohrung (9) des Greiforgans (6) und zum Photosensor (18) gelangt, **dadurch gekennzeichnet, dass** in der Längsbohrung (9) des Greiforgans (6) ein mit einer spiegelnden Fläche ausgebildeter Körper (15) angeordnet ist, der von unten in die Längsbohrung (9) des Greiforgans (6) einfallendes Licht in eine horizontale Ebene (17) umlenkt, dass das Greiforgan (6) für das Licht der Lichtquelle (10) durchlässige Stellen aufweist, und dass am Bondkopf (5) mindestens ein optisches Element (19; 19.1, 19.2) angeordnet ist, das wenigstens einen Teil des umgelenkten, seitlich aus dem Greiforgan (6) austretenden Lichtes auf dem Photosensor (18) konzentriert.

2. Vorrichtung nach Anspruch 1, **dadurch gekennzeichnet, dass** das optische Element (19) ein Reflektor mit der Form einer Ellipse ist, wobei die spiegelnde Fläche des Körpers (15) im ersten Brennpunkt (20) und der Photosensor (18) im zweiten Brennpunkt (21) der Ellipse angeordnet sind.

3. Vorrichtung nach Anspruch 1, **dadurch gekennzeichnet, dass** das optische Element (19.1) eine Linse ist und dass ein zweites optisches Element (19.2) in Gestalt eines Reflektors vorhanden ist.

4. Vorrichtung nach Anspruch 1, **dadurch gekennzeichnet, dass** das optische Element (19.1) eine Linse ist und dass der Photosensor (18) in einem Brennpunkt der Linse angeordnet ist.

5. Vorrichtung nach einem der Ansprüche 1 bis 4, **dadurch gekennzeichnet, dass** das bzw. die optischen Elemente (19) und der Photosensor (18) in einem lichtundurchlässigen Gehäuse untergebracht sind.

6. Vorrichtung nach einem der Ansprüche 1 bis 5, **dadurch gekennzeichnet, dass** weiter eine Linse (25) vorhanden ist, um einen Lichtstrahl aus annähernd parallelen Lichtstrahlen (23) zu erzeugen, wobei die Lichtquelle (24) in einem Brennpunkt der Linse (25) angeordnet ist.

## Claims

1. Apparatus for the mounting of semiconductor chips, with a bondhead (5) with a pick-up tool (6) with a longitudinal drill hole (9) to which vacuum can be applied for the gripping and transport of a semiconductor chip (7), and with a light source (10) and a photosensor (18) to detect whether the pick-up tool (6) has gripped the semiconductor chip (7), whereby on the absence of the semiconductor chip (7) light from the light source (10) accesses into the longitudinal drill hole (9) of the pick-up tool (6) and to the photosensor (18), **characterised in that** a body (15) formed with a reflective surface is arranged in the longitudinal drill hole (9) of the pick-up tool (6) which deflects light shining from underneath into the longitudinal drill hole (9) of the pick-up tool (6) into a horizontal plane (17), that the pick-up tool (6) has locations pervious to the light of the light source (10), and that at least one optical element (19; 19.1, 19.2) is arranged on the bondhead (5) which concentrates at least a part of the deflected light emerging laterally from the pick-up tool (6) onto the photosensor (18).

2. Apparatus according to claim 1, **characterised in that** the optical element (19) is a reflector in the form of an ellipse, whereby the reflecting surface of the body (15) is arranged in the first focal point (20) and the photosensor (18) is arranged in the second focal point (21) of the ellipse.

3. Apparatus according to claim 1, **characterised in that** the optical element (19.1) is a lens and that a second optical element (19.2) in the form of a reflector is present.

4. Apparatus according to claim 1, **characterised in that** the optical element (19.1) is a lens and that the photosensor (18) is arranged in a focal point (21) of the lens.

5. Apparatus according to any of claims 1 to 4, **characterised in that** the optical element or elements (19) and the photosensor (18) are installed in a housing which is impervious to light.

6. Apparatus according to any of claims 1 to 5, **characterised in that** further a lens (25) is provided in order to produce a light beam of almost parallel light beams (23), whereby the light source (24) is arranged in a focal point of the lens (25).

## Revendications

1. Dispositif pour le montage de puces à semi-conducteurs, comprenant une tête de montage (5) dotée d'un organe de préhension (6), un perçage longitudinal (9) soumis à une dépression afin de saisir et de transporter une puce à semi-conducteurs (7), et une source de lumière (10) et un capteur photoélectrique (18) pour prouver si l'organe de préhension (6) a saisi la puce à semi-conducteurs (7), dans lequel, en l'absence de la puce à semi-conducteurs (7), de la lumière de la source de lumière (10) arrive jusque dans le perçage longitudinal (9) de l'organe de préhension (6) et vers le capteur photoélectrique (18), **caractérisé en ce qu'**un corps (15) réalisé avec une surface réfléchissante est agencé dans le perçage longitudinal (9) de l'organe de préhension (6), lequel dévie par le bas la lumière incidente dans le perçage longitudinal (9) de l'organe de préhension (6) dans un plan horizontal (17), **en ce que** l'organe de préhension (6) présente des endroits perméables à la lumière de la source de lumière (10), en **en ce qu'**au moins un élément optique (19 ; 19.1, 19.2) est agencé sur la tête de montage (5), lequel concentre au moins une partie de la lumière déviée qui sort latéralement de l'organe de préhension (6) sur le capteur photoélectrique (18).

2. Dispositif selon la revendication 1, **caractérisé en ce que** l'élément optique (19) est un réflecteur ayant la forme d'une ellipse, dans lequel la surface réfléchissante du corps (15) est agencée dans le premier foyer (20) et dans lequel le capteur photoélectrique (18) est agencé dans le second foyer (21) de l'ellipse.

3. Dispositif selon la revendication 1, **caractérisé en ce que** l'élément optique (19.1) est une lentille et **en ce qu'**un second élément optique (19.2) est présent sous la forme d'un réflecteur.

4. Dispositif selon la revendication 1, **caractérisé en ce que** l'élément optique (19.1) est une lentille et **en ce que** le capteur photoélectrique (18) est agencé dans un foyer de la lentille.

5. Dispositif selon l'une des revendications 1 à 4, **caractérisé en ce que** l'élément optique ou les éléments optiques (19) et le capteur photoélectrique (18) sont agencés dans un boîtier imperméable à la lumière.

6. Dispositif selon l'une des revendications 1 à 5, **caractérisé en ce qu'**une lentille supplémentaire (25) est présente afin de générer un rayon de lumière depuis des rayons de lumière approximativement parallèles (23), dans lequel la source de lumière (24) est agencée dans un foyer de la lentille (25).
